Europäisches Patentamt

European Patent Office

Office européen des brevets

(11) Numéro de publication: **0 350 412**
**A1**

## DEMANDE DE BREVET EUROPEEN

(21) Numéro de dépôt: 89402095.7

(22) Date de dépôt: 04.07.89

(51) Int. Cl.⁵: **G 11 B 5/255**
G 11 B 5/72

(30) Priorité: 05.07.88 FR 8809068

(43) Date de publication de la demande:
10.01.90 Bulletin 90/02

(84) Etats contractants désignés: ES GR

(71) Demandeur: THOMSON-CSF
51, Esplanade du Général de Gaulle
F-92800 Puteaux (FR)

(72) Inventeur: Meunier, Paul-Louis
THOMSON-CSF SCPI - CEDEX 67
F-92045 Paris La Défense (FR)

Coutellier, Jean-Marie
THOMSON-CSF SCPI - CEDEX 67
F-92045 Paris La Défense (FR)

Razeghi, Manijeh
THOMSON-CSF SCPI - CEDEX 67
F-92045 Paris La Défense (FR)

Mackowski, Jean Marie
THOMSON-CSF SCPI - CEDEX 67
F-92045 Paris La Défense (FR)

(74) Mandataire: Grynwald, Albert et al
THOMSON-CSF SCPI
F-92045 PARIS LA DEFENSE CEDEX 67 (FR)

(54) Dispositif en matériau magnétique à couche anti-usure et applications à une tête d'enregistrement-lecture et à un disque d'enregistrement.

(57) Dispositif en matériau magnétique comportant un matériau magnétique fritté (1) affleurant une surface active du dispositif (cette surface peut être la surface active d'une tête magnétique) dans lequel on prévoit une couche d'accrochage (2) en silice par exemple et une couche en carbone (3).
Application : Têtes magnétiques d'enregistrement. Lecture et supports d'enregistrement.

FIG_1

## Description

## DISPOSITIF EN MATERIAU MAGNETIQUE A COUCHE ANTI-USURE ET APPLICATIONS A UNE TETE D'ENREGISTREMENT-LECTURE ET A UN DISQUE D'ENREGISTREMENT

L'invention concerne un dispositif en matériau magnétique à couche anti-usure et des applications à une tête d'enregistrement-lecture, et un disque d'enregistrement magnétique.

Dans la technique des têtes magnétiques réalisées en couches minces, le problème de l'usure est crucial notamment pour les appareils d'enregistrement-lecture à bandes magnétiques.

Une tête type VHS s'use de 20 micromètres en 2000 heures d'utilisation de bande circulant à 5 mètres par seconde.

Pour protéger ces têtes, on peut déposer un revêtement très mince (quelques centaines d'Angstroems) de carbone, CSi, Zr par exemple.

Vu l'hétérogénéité des têtes : ferrite - sendust ou permalloy - $Al_2 O_3$ - Verre, il est rare qu'un type de matériau accroche sur toute une surface pour les mêmes conditions de dépôt (plasma par exemple).

Il convient donc de protéger ces têtes magnétiques par une couche d'un matériau présentant une bonne résistance à l'usure.

Un matériau qui conviendrait parfaitement pour assurer cette protection contre l'usure est le carbone. Cependant, il a été constaté qu'une couche mince de carbone (250 Angstroems) adhère difficilement sur des matériaux type ferrite. Ceci a été prouvé en laboratoire, par des tests d'usure sur tête carbone.ferrite.

C'est pourquoi, l'invention fournit une solution permettant de résoudre ce problème.

L'invention concerne donc un dispositif en matériau magnétique comportant au moins un matériau magnétique fritté affleurant une des faces du dispositif, caractérisé en ce qu'il comporte au moins une couche de protection en matériau à base d'un composé à base de carbone protégeant ladite face contre une usure.

Plus particulièrement, l'invention concerne un dispositif dans lequel le matériau fritté est un matériau en ferrite et dans lequel la couche de protection comporte une couche d'accrochage à base de silicium recouvrant ladite face, cette couche d'accrochage à base d'un constituant ayant un bon coefficient d'accrochage sur le matériau en ferrite et recouvrant ladite face, cette couche d'accrochage étant elle-même recouverte d'une couche anti-usure à base de carbone protégeant ladite face contre une usure.

L'invention concerne également une tête magnétique d'enregistrement-lecture comprenant au moins deux couches en matériau ferrite encadrant une couche d'entrefer en matériau non magnétique, ces trois couches affleurant une surface active d'enregistrement-lecture de la tête, appliquant le dispositif précédent et dans lequel la couche de protection recouvre la surface active de la tête.

Les différents objets et caractéristiques de l'invention apparaîtront de façon plus détaillée dans la description qui va suivre faite à titre d'exemple en se reportant aux figures annexées qui représentent :

- la figure 1, un exemple de réalisation du dispositif de l'invention ;
- la figure 2, un exemple de réalisation d'une tête magnétique d'enregistrement-lecture selon l'invention ;
- la figure 3, un autre exemple de réalisation d'une tête magnétique d'enregistrement-lecture selon l'invention ;
- la figure 4, un exemple de réalisation d'un disque d'enregistrement magnétique.

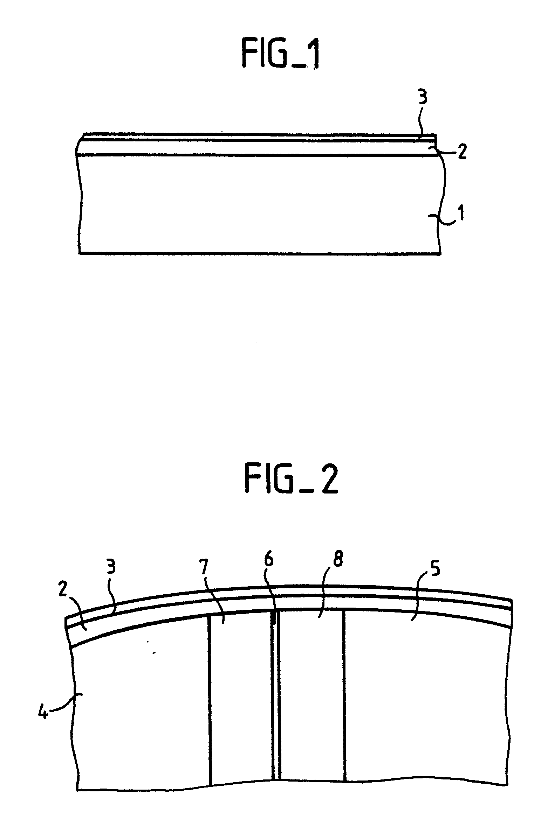

En se reportant à la figure 1, on va tout d'abord décrire un dispositif magnétique selon l'invention dans lequel le dispositif comporte au moins une couche 1 en matériau magnétique, telle que de la ferrite, que l'on veut protéger contre l'usure.

Il a été démontré en laboratoire que le carbone type adiamentin accrochait parfaitement sur une surface en silice. Par ailleurs, la silice adhère parfaitement sur des matériaux type ferrite.

Le dispositif de l'invention comporte donc sur la couche 1, une couche 2 en silice ($SiO_2$), laquelle est revêtue d'une couche 3 en carbone adamantin.

Il a été prouvé qu'un très léger dépôt de C ( 30 Å), c'est à dire un temps de dépôt de quelques secondes, est suffisant pour rendre la surface de silice très dure.

De façon plus générale, la couche 2 est à base d'un matériau qui accroche au substrat et plus particulièrement à base de silicium (sans être précisément de la silice ou du titane). De même, la couche 3 peut être un matériau à base de carbone.

Selon une variante de réalisation, les couches 2 et 3 peuvent être réalisées en une seule couche et leur composition, en silicium et en carbone, est choisie de façon d'une part à obtenir un bon accrochage sur la couche 1 et à fournir une bonne protection contre l'usure.

La figure 2, représente un exemple de réalisation d'une tête magnétique mettant en application le dispositif de protection selon l'invention.

Cependant l'invention est également applicable à la protection contre l'usure de tout type de têtes permettant de lire un support magnétique y compris les têtes à base de grenat destinées à détecter la répartition des champs magnétiques sur un support magnétique et se prêtant à une détection optique des transitions magnétiques.

Cette tête magnétique comporte deux couches 4 et 5 en matériau magnétique tel qu'un matériau à base de ferrite. Les deux couches 4 et 5 sont séparées par un matériau non magnétique d'entrefer 6. De plus, dans certaines têtes magnétiques telles que celle de la figure 2, entre la couche d'entrefer 6 et les couches 4 et 5, ont été prévues deux couches 7 et 8 en matériau magnétique du type Sendust (alliage de Fer-Silicium-Aluminium).

Selon l'invention l'ensemble de la tête soumise à une usure est recouverte par une couche 2 d'oxyde de silicium (silice) $SiO_2$. La couche 2 est recouverte par une couche 3 de carbone. Ces couches protègent ainsi la couche active de la tête magnétique sur laquelle frotte le support magnétique d'enregistrement telle qu'une bande magnétique. Elles peuvent également recouvrir les flancs de la tête.

La couche 2 permet l'accrochage efficace sur la ferrite des couches 4 et 5 sur les couches 7 et 8 (Sendust). Son épaisseur peut être de 100 à 200 Angstroems.

La couche 3 s'accroche bien sur la couche 2 et permet une protection efficace contre l'usure. Son épaisseur peut être de 20 à 50 Angstroems, par exemple, selon le temps d'utilisation que l'on désire obtenir.

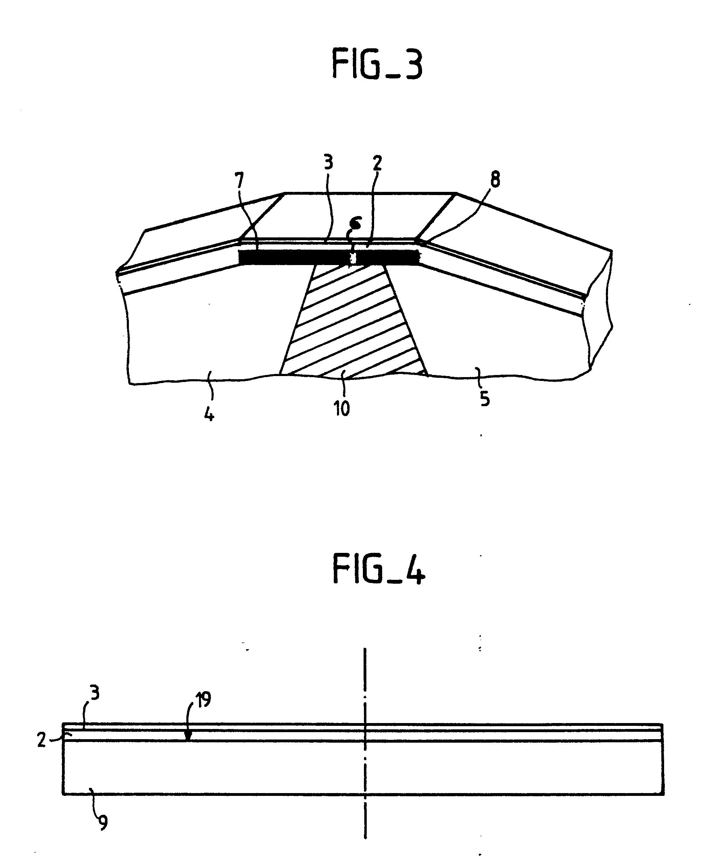

La figure 3, représente une tête magnétique dans laquelle l'entrefer 6 de la tête est réalisé par les deux couches 7 et 8 de sendust situées à plat sur deux parties en ferrite 4 et 5 séparées par du matériau isolant 10 du type verre. Ces couches 7 et 8 constituent alors une partie essentielle de la surface active de la tête. Comme la tête magnétique de la figure 2, la tête magnétique de la figure 3 comporte une couche d'accrochage 2 en oxyde de silicium ($SiO_2$) et une couche anti-usure 3 en carbone adamantin. Les épaisseurs de ces couches peuvent être celles indiquées précédemment par la tête magnétique de la figure 2.

La figure 4, représente un disque magnétique d'enregistrement de données informatiques appelé usuellement disque dur. Il comporte le disque magnétique proprement dit recouvert sur sa face active 19 d'une couche d'accrochage 2 (en oxyde de silicium ou silicium amorphe polycristallin ou monocristallin) laquelle est recouverte d'une couche anti-usure 3 (en carbone adamentin). A titre d'exemple, la couche d'accrochage peut avoir 100 à 200 Angstroems d'épaisseur et la couche anti-usure 3 peut avoir 20 à 50 Angstroems d'épaisseur.

Pour la réalisation de telles couches de protection, si l'on considère un dépôt de type plasma, les dispositifs à protéger telles que les têtes magnétiques sont dans la même enceinte et on dépose le silicium, par l'intermédiaire de gaz tel que le silane, ou la silice par silane et oxygène. On peut régler les conditions de dépôt pour obtenir un type donné de silice. Le dépôt peut atteindre une épaisseur de 200 Angstroems environ.

Ensuite sans détruire le vide, de l'enceinte, on dépose pendant un temps très court (quelques secondes) la couche de carbone adiamentin.

Cette méthode s'applique aussi au Sputtering (pulvérisation cathodique), il suffit de disposer des cibles appropriées de silicium et de graphite. Ceci s'effectue dans la même étape de dépôt.

On peut aussi effectuer ce dépôt par tout autre dépôt d'épitaxie connu.

On peut aussi faire des mélange des deux composants (silicium et carbone) en utilisant le Dual Ion Beam Sputtering (une cible Si, une cible C).

Il est bien évident que la description qui précède n'a été faite qu'à titre d'exemple non limitatif. D'autre variantes peuvent être envisagées sans sortir du cadre de l'invention. Notamment les exemples numériques n'ont été fournis que pour illustrer la description.

## Revendications

1. Dispositif en matériau magnétique comportant au moins un matériau magnétique fritté (1) affleurant une des faces (10) du dispositif, caractérisé en ce qu'il comporte au moins une couche de protection en matériau à base d'un composé de carbone protégeant ladite face contre une usure.

2. Dispositif en matériau magnétique selon la revendication 1, caractérisé en ce que le matériau magnétique fritté (1) est un matériau en ferrite, la couche de protection comporte une couche d'accrochage (2) à base d'un constituant ayant un bon coefficient d'accrochage sur le matériau en ferrite et recouvrant ladite face, cette couche d'accrochage (2) étant elle-même recouverte d'une couche (3) anti-usure à base de carbone protégeant ladite face contre une usure.

3. Dispositif en matériau magnétique selon la revendication 2, caractérisé en ce que le constituant d'accrochage de la couche d'accrochage (2) est du titane.

4. Dispositif en matériau magnétique selon la revendication 2, caractérisé en ce que le constituant d'accrochage de la couche d'accrochage (2) est du titane.

5. Dispositif en matériau magnétique selon la revendication 3, caractérisé en ce que la couche à base de silicium (2) est de la silice ($SiO_2$ ou $SiO_x$).

6. Dispositif en matériau magnétique selon la revendication 2, caractérisé en ce que la couche anti-usure (3) à base de carbone est en carbone adamentin ou carbone à structure diamant.

7. Tête magnétique d'enregistrement-lecture comprenant au moins deux couches en matériau ferrite (4, 5) encadrant une couche d'entrefer (6) en matériau non magnétique, ces trois couches affleurant une surface active (10) d'enregistrement-lecture de la tête, appliquant le dispositif selon l'une quelconque des revendications 1 à 6, caractérisée en ce que la couche de protection recouvre la surface active (10) de la tête.

8. Tête magnétique d'enregistrement-lecture selon la revendication 7, caractérisée en ce que la couche de protection comporte une couche d'accrochage (2) à base de silicium qui recouvre la surface active (10) de la tête et une couche anti-usure (3) à base de carbone qui recouvre la couche d'accrochage (2).

9. Tête magnétique d'enregistrement-lecture selon la revendication 7, caractérisée en ce qu'elle comporte, affleurant la surface active (10) de la tête, un matériau métallique (7, 8) située entre chaque couche (4, 5) en matériau à base de ferrite et la couche d'entrefer (6).

# FIG_1

# FIG_2

# FIG_3

# FIG_4

Office européen
des brevets

**RAPPORT DE RECHERCHE EUROPEENNE**

Numéro de la demande

EP    89 40 2095

Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | US-A-4713279 (FUJIWARA ET AL.)<br>* colonne 1, lignes 41 - 50 *<br>* colonne 3, lignes 34 - 57 *<br>* colonne 4, ligne 62 - colonne 5, ligne 23; revendication 13; figure 1B * | 1-3, 5 | G11B5/255<br>G11B5/72 |
| A | PATENT ABSTRACTS OF JAPAN<br>vol. 8, no. 257 (P-316)(1694) 24 novembre 1984,<br>& JP-A-59 127232 (SUWA SEIKOSHA K.K.) 23 juillet 1984,<br>* le document en entier * | 1, 2, 6 | |
| A | PATENT ABSTRACTS OF JAPAN<br>vol. 9, no. 83 (P-348)(1806) 12 avril 1985,<br>& JP-A-59 213030 (DENKI KAGAKU KOGYO K.K.) 01 décembre 1984,<br>* le document en entier * | 1-4, 6 | |
| Y | PATENT ABSTRACTS OF JAPAN<br>vol. 5, no. 69 (P-60)(741) 09 mai 1981,<br>& JP-A-56 19517 (MATSUSHITA DENKI SANGYO K.K.) 24 février 1981,<br>* le document en entier * | 1, 7, 8 | DOMAINES TECHNIQUES RECHERCHES (Int. Cl.5 ) |
| A | | 2, 4, 5 | G11B |
| Y | FR-A-2474219 (EUROFARAD-EFD)<br>* revendications 1, 6; figures 1, 2 * | 1, 7, 8 | |
| A | PATENT ABSTRACTS OF JAPAN<br>vol. 5, no. 69 (P-60)(741) 09 mai 1981,<br>& JP-A-56 19518 (MATSUSHITA DENKI SANGYO K.K.) 24 février 1981,<br>* le document en entier * | 1, 2, 4, 5, 7, 8 | |
| A | PATENT ABSTRACTS OF JAPAN<br>vol. 10, no. 48 (P-431)(2105) 25 février 1986,<br>& JP-A-60 193112 (SEIKO DENSHI KOGYO K.K.) 01 octobre 1985,<br>* le document en entier * | 1, 2, 6, 7 | |

Le présent rapport a été établi pour toutes les revendications

| Lieu de la recherche | Date d'achèvement de la recherche | Examinateur |
|---|---|---|
| LA HAYE | 13 OCTOBRE 1989 | FUX J. |

Office européen
des brevets

# RAPPORT DE RECHERCHE EUROPEENNE

Numero de la demande

EP    89 40 2095
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | EP-A-123826 (SIEMENS AKTIENGESELLSCAFT) <br> * revendications 1, 2, 4; figure 1 * | 1, 7 | |
| A | EP-A-241371 (THOMSON-CSF) <br> * colonne 3, lignes 31 - 41; revendications 17, 24, 30-32; figure 4 * | 1, 2, 3, 7, 8 | |
| A | EP-A-240088 (KOMAG, INC.) <br> * page 5, lignes 18 - 32 * <br> * page 15, lignes 17 - 33 * <br> * page 16, lignes 5 - 11; revendications 16, 18 * | 1, 2, 4 | |
| P,X | WO-A-8806334 (AKASHIC MEMORIES CORPORATION) <br> * page 2, lignes 24 - 37 * <br> * page 3, ligne 17 - page 4, ligne 7; revendications 1, 2, 6, 9, 13; figure 1 * | 1, 2, 7 | |

DOMAINES TECHNIQUES RECHERCHES (Int. Cl.5 )

Le présent rapport a été établi pour toutes les revendications

| Lieu de la recherche | Date d'achèvement de la recherche | Examinateur |
|---|---|---|
| LA HAYE | 13 OCTOBRE 1989 | FUX J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

&  : membre de la même famille, document correspondant

EPO FORM 1503 03.82 (P0402)